# FASCICULE DE BREVET EUROPEEN

(11) **EP 2 620 404 B1**
(45) Date de publication et mention de la délivrance du brevet: **10.09.2014**
(21) Numéro de dépôt: 13151909.2
(22) Date de dépôt: 18.01.2013
(51) Int. Cl.: B66B 1/46, G01R 27/16

(54) **Module pour le contrôle auditif d'appel d'un ascenseur et procédé de contrôle correspondant**
Modul für die akustische Kontrolle des Aufzugsrufs, und entsprechendes Verfahren zur Kontrolle
Module for auditory control of the calling of a lift and corresponding control method

(30) Priorité: 24.01.2012 FR 1250654
(43) Date de publication de la demande: 31.07.2013
(73) Titulaire: OCTE, 28170 Chateauneuf en Thymerais (FR)
(72) Inventeur: Marty, Jacques, 81580 SOUAL (FR)
(74) Mandataire: Laget, Jean-Loup

(56) Documents cités:
- FR-A1- 2 896 883
- GB-A- 2 164 173
- JP-A- 2002 053 274
- US-A1- 2009 153 156
- US-B2- 7 562 748

## Description

L'invention concerne un module pour le contrôle auditif d'appel d'un ascenseur et un procédé de contrôle correspondant.

Pour le respect des normes en vigueur, les installations d'ascenseur doivent être équipées d'un contrôle auditif d'appel de façon à permettre à l'usager, qui appelle un ascenseur par pression sur le bouton d'appel, de contrôler par voie auditive que son appel a été enregistré.

Usuellement, une pression sur le bouton d'appel assure la fermeture temporaire d'un contact, qui entraîne d'une part l'allumage d'un voyant lumineux au niveau du bouton d'appel et d'autre part la fermeture, dans l'armoire de manoeuvre, d'un contact correspondant à l'étage du bouton d'appel. Cette fermeture de contact dans l'armoire est assurée par un relais ou un transistor qui assure le maintien du contact fermé jusqu'à l'arrêt de la cabine d'ascenseur à l'étage du bouton d'appel.

En général, le contact fermé, et maintenu fermé, par le relais dans l'armoire de manoeuvre, est monté en parallèle sur le contact fermé par la pression sur le bouton d'appel, et qui ne reste fermé que pendant la pression sur le bouton d'appel.

Si l'usager ne peut pas voir que le voyant lumineux est allumé, et s'il appuie à nouveau sur le bouton d'appel, il faut lui assurer le contrôle par voie auditive de son appel, c'est-à-dire le contrôle de la fermeture du contact au niveau du bouton d'appel quel que soit l'état du contact de l'armoire.

Le document JP 2002 053274 décrit un bouton d'ascenseur avec confirmation acoustique.

L'un des buts de l'invention est de proposer un module pour le contrôle auditif d'appel d'un ascenseur qui assure l'émission d'un signal audible lors de la pression sur le bouton d'appel même lorsque le contact de l'armoire est maintenu fermé.

Un autre but de l'invention est de proposer un module pour le contrôle auditif d'appel d'un ascenseur, apte à être logé dans les boîtiers de bouton d'appel de chaque palier, aussi bien pour les installations neuves que pour les installations en rénovation.

L'invention a pour objet un module pour le contrôle auditif d'appel d'un ascenseur, dont l'installation comporte une armoire de manoeuvre et des boîtiers de palier équipés chacun d'un bouton de commande d'appel et d'un voyant lumineux de contrôle d'appel, chaque boîtier de palier étant relié à l'armoire de manoeuvre par un conducteur de masse, et un conducteur de lecture, entre lesquels sont disposés un contact d'armoire et un contact de palier, caractérisé en ce que le module comporte un condensateur de mesure relié audit conducteur de lecture, un générateur d'impulsions délivrant des impulsions au condensateur de mesure, un circuit de mesure mesurant la charge du condensateur de mesure, un comparateur comparant ladite mesure de la charge du condensateur de mesure à une valeur de seuil, et un circuit logique contrôlant, en fonction de l'état de sortie du comparateur, un émetteur sonore.

Avantageusement, le circuit logique contrôle le générateur d'impulsions et un circuit de décharge qui procède à la décharge du condensateur de mesure avant la délivrance de chaque impulsion par le générateur d'impulsions.

De manière avantageuse, le condensateur de mesure est relié au conducteur de lecture par l'intermédiaire d'un condensateur d'isolement.

Avantageusement, les impulsions délivrées au condensateur de mesure ont une amplitude inférieure à 0,6 V et une durée inférieure à 1 µs.

De préférence, les impulsions délivrées au condensateur de mesure ont une amplitude de 0,5 V et une durée de 0,3 µs.

L'invention a aussi pour objet un procédé de contrôle auditif d'appel d'un ascenseur équipé d'un module de contrôle auditif tel que décrit ci-dessus, caractérisé par les étapes de :
- mesurer, au moyen d'une impulsion, la charge du condensateur de mesure en fonction de l'impédance apparente du circuit des contacts d'armoire et de palier,
- comparer le résultat de la mesure à une valeur de seuil,
- en fonction du résultat de la comparaison, déclencher l'émission d'un signal sonore.

Avantageusement, l'émission d'un signal sonore est déclenchée lorsque l'impédance apparente du circuit des contacts est inférieure à 50 Ω, correspondant à l'état fermé du contact de palier, quel que soit l'état du contact d'armoire.

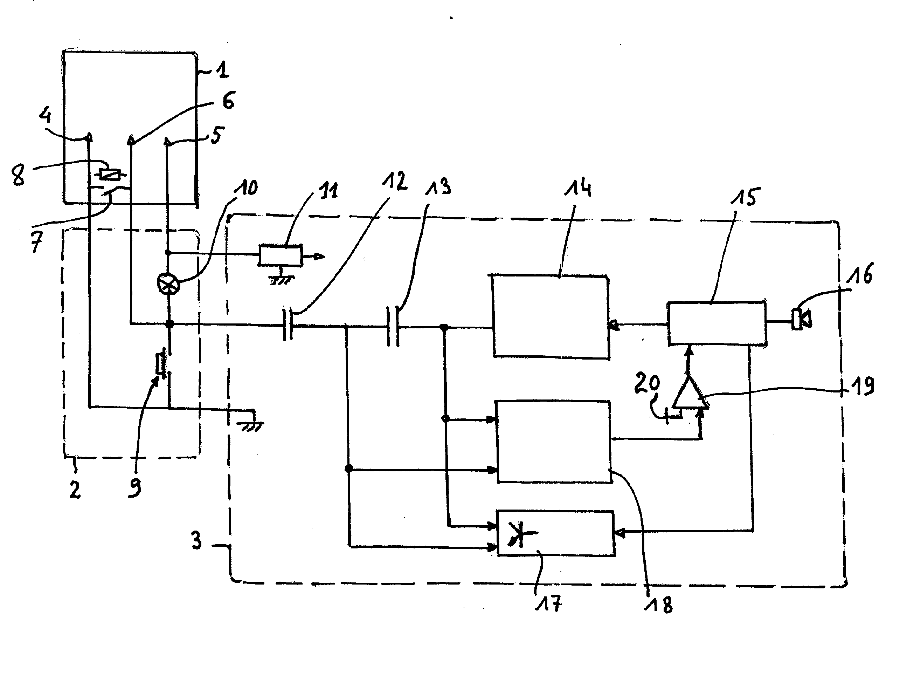

D'autres détails, caractéristiques et avantages de l'invention ressortiront de la description suivante d'un mode de réalisation de l'invention, donné à titre illustratif et non limitatif, en référence au dessin annexé représentant un schéma symbolique simplifié d'un module pour le contrôle auditif d'appel d'un ascenseur.

Sur le dessin, sont représentés trois sous-ensembles : une armoire de manoeuvre 1, un boîtier de palier 2, et un module 3 pour le contrôle auditif d'appel d'un ascenseur.

L'armoire de manoeuvre 1 est symbolisée par trois conducteurs, respectivement un conducteur de masse 4, un conducteur d'alimentation continue 5 et un conducteur de lecture 6. Entre le conducteur de lecture 6 et le conducteur de masse 4 est représenté un contact 7 qui est fermé, et maintenu fermé, par un relais ou un transistor symbolisé en 8.

Dans le boîtier de palier 2 sont logés un contact 9 apte à être fermé par pression sur le bouton d'appel et un voyant lumineux 10 de contrôle d'appel. Dans l'exemple de réalisation décrit, le contact 9 est disposé entre les conducteurs de masse 4 et de lecture 6, en parallèle sur le contact 7 d'armoire. Le voyant lumineux 10 est disposé entre les conducteurs d'alimentation 5 et de lecture 6.

Le module 3 est relié directement et exclusivement au boîtier de palier (2). Il comporte une masse reliée au conducteur de masse 4 et une alimentation 11 reliée au conducteur d'alimentation 5. Le module 3 est relié au conducteur de lecture 6 par l'intermédiaire d'un condensateur 12 d'isolement par rapport au courant continu venant de l'armoire 1.

Le module 3 comporte, en série avec le condensateur d'isolement 12, un condensateur de mesure 13 et un générateur d'impulsions 14. Un circuit logique 15 contrôle d'une part le générateur d'impulsions 14, d'autre part un émetteur sonore 16.

En parallèle sur le condensateur de mesure 13 sont montés d'une part un circuit de décharge 17, d'autre part un circuit de mesure de charge 18.

Entre le circuit de mesure de charge 18 et le circuit logique 15 est disposé un comparateur 19 dont l'entrée de référence 20 reçoit une valeur de seuil de détection.

Le circuit compris entre le conducteur de lecture 6 et le conducteur de masse 4, est constitué essentiellement du contact de palier 9 et du contact d'armoire 7, qui sont en parallèle. Le contact de palier 9 est un contact local, situé à environ 10 cm du module 3. Le contact d'armoire 7 est un contact distant, situé à environ 10 m du module 3.

Entre le contact local de palier 9 et le contact distant d'armoire 7, la longueur des câbles de liaison colinéaires est d'environ 10 m. Pour simplifier, le circuit comprenant le contact local de palier, le contact distant d'armoire et les câbles de liaison est appelé circuit des contacts (7, 9).

Le module 3 procède périodiquement à la mesure de la charge du condensateur de mesure 13. A cet effet, le générateur d'impulsions 14 délivre au condensateur de mesure 13 des impulsions de durée inférieure ou égale à 1 µs et d'amplitude inférieure ou égale à 0,6 V. De préférence, les impulsions ont une durée de 0,3 µs et une amplitude de 0,5 V, et elles sont délivrées par le générateur d'impulsions 14 avec une fréquence de 100/s commandée par le circuit logique 15. Avant chaque impulsion, le circuit logique 15 commande, par l'intermédiaire du circuit de décharge 17, la décharge du condensateur de mesure 13. Lors de chaque impulsion, le condensateur de mesure 13 se charge en fonction de l'impédance apparente du circuit des contacts (7, 9). Après chaque impulsion, le circuit de mesure de charge 18 mesure la charge accumulée dans le condensateur de mesure 13 et applique le résultat à l'entrée de mesure du comparateur 19 dont l'entrée de référence 20 reçoit une valeur de seuil de détection.

Si le contact de palier 9 est ouvert, la charge mesurée du condensateur de mesure 13 correspond à une impédance apparente du circuit des contacts supérieure à 50 Ω, le comparateur 19 ne change pas d'état de sortie et l'émetteur sonore 16 n'est pas activé.

Si le contact de palier 9 est fermé, la charge mesurée du condensateur de mesure 13 correspond à une impédance apparente du circuit des contacts inférieure à 50 Ω, le comparateur 19 change d'état de sortie et le circuit logique 15 active l'émetteur sonore 16 qui émet un signal sonore identifié comme un bip.

Il faut remarquer qu'une impédance apparente de 50 Ω correspond à une inductance de ligne d'environ 10 µH. Cette valeur correspond, pour le type de câble utilisé dans les installations d'ascenseur, à une longueur de câbles colinéaires de 2 à 3 m.

Les changements d'état du contact de palier 9, ou contact local, sont donc bien pris en compte, alors que les changements d'état du contact d'armoire 7, ou contact distant, ne sont pas perçus, lors de la charge du condensateur de mesure 13. C'est pourquoi le signal sonore est émis chaque fois que le contact de palier 9 est fermé, quel que soit l'état du contact d'armoire 7. Ainsi, que le contact d'armoire 7 soit ouvert, ou maintenu fermé après une pression antérieure sur le bouton d'appel, le signal sonore est délivré à chaque pression sur le bouton d'appel provoquant la fermeture temporaire du contact de palier 9.

Le fait de limiter la durée et l'amplitude des impulsions délivrées par le générateur d'impulsions 14 a pour objet de ne pas perturber les circuits internes de l'armoire de manoeuvre 1.

Le module 3 est de dimensions suffisamment petites pour être logeable dans le boîtier de palier 2. Il est adaptable aux différentes tensions continues des armoires de manoeuvre, de 10 à 30 V. Il est adaptable sur tout type d'armoire, et indifférent aux moyens de commande du contact d'armoire 7 (transistor ou relais). Il peut être branché en utilisant les seuls conducteurs déjà présents dans le boîtier de palier 2. Il peut être branché quelle que soit la polarité d'alimentation du voyant lumineux et du bouton d'appel. Il ne perturbe pas l'armoire de manoeuvre.

Le module 3 ne commande l'émission d'un signal sonore que lorsque le contact local se ferme. Il est insensible à la fermeture du contact distant. Le circuit logique 15 est de préférence un microprocesseur. Le module 3 peut être adapté sans difficulté au cas d'un boîtier de palier à deux boutons de commande, l'un pour la montée, l'autre pour la descente. Dans ce cas, le microprocesseur peut contrôler deux circuits de mesure, un pour chaque bouton de commande.

Le procédé de contrôle auditif d'appel d'un ascenseur équipé d'un module 3 de contrôle auditif tel que décrit ci-dessus comprend les étapes de :
- mesurer, au moyen d'une impulsion, la charge du condensateur de mesure 13, en fonction de l'impédance apparente du circuit des contacts d'armoire 7 et de palier 9,
- comparer le résultat de la mesure à une valeur de seuil,
- en fonction du résultat de la comparaison, déclencher l'émission d'un signal sonore.

L'émission du signal sonore est déclenchée lorsque l'impédance apparente du circuit des contacts (7, 9) est inférieure à 50 Ω, ce qui correspond à l'état fermé du contact de palier 9, quel que soit l'état du contact d'armoire 7.

L'invention a été décrite en liaison avec un mode de réalisation particulier auquel elle n'est pas limitée. Elle comprend les équivalents techniques des moyens décrits pour autant qu'ils ne sortent pas du cadre de l'invention telle que définie dans les revendications annexées.

## Revendications

1. Module pour le contrôle auditif d'appel d'un ascenseur, dont l'installation comporte une armoire de manoeuvre (1) et des boîtiers de palier (2) équipés chacun d'un bouton de commande d'appel et d'un voyant lumineux de contrôle d'appel, chaque boîtier de palier (2) étant relié à l'armoire de manoeuvre (1) par un conducteur de masse (4), et un conducteur de lecture (6), entre lesquels sont disposés un contact d'armoire (7) et un contact de palier (9), **caractérisé en ce que** le module (3) comporte un condensateur de mesure (13) relié audit conducteur de lecture (6), un générateur d'impulsions (14) délivrant des impulsions au condensateur de mesure (13), un circuit de mesure (18) mesurant la charge du condensateur de mesure (13), un comparateur (19) comparant ladite mesure de la charge du condensateur de mesure (13) à une valeur de seuil, et un circuit logique (15) contrôlant, en fonction de l'état de sortie du comparateur (19), un émetteur sonore (16).

2. Module selon la revendication 1 **caractérisé en ce que** le circuit logique (15) contrôle le générateur d'impulsions (14) et un circuit de décharge (17) qui procède à la décharge du condensateur de mesure (13) avant la délivrance de chaque impulsion par le générateur d'impulsions (14).

3. Module selon la revendication 1 **caractérisé en ce que** le condensateur de mesure (13) est relié au conducteur de lecture (6) par l'intermédiaire d'un condensateur (12) d'isolement.

4. Module selon la revendication 1 **caractérisé en ce que** les impulsions délivrées au condensateur de mesure (13) ont une amplitude inférieure à 0,6 V et une durée inférieure à 1 µs.

5. Module selon la revendication 4 **caractérisé en ce que** les impulsions délivrées au condensateur de mesure (13) ont une amplitude de 0,5 V et une durée de 0,3 µs.

6. Procédé de contrôle auditif d'appel d'un ascenseur équipé d'un module de contrôle auditif selon l'une des revendications 1 à 5, **caractérisé par** les étapes de :
- mesurer, au moyen d'une impulsion, la charge du condensateur de mesure (13) en fonction de l'impédance apparente du circuit des contacts d'armoire (7) et de palier (9),
- comparer le résultat de la mesure à une valeur de seuil,
- en fonction du résultat de la comparaison, déclencher l'émission d'un signal sonore.

7. Procédé selon la revendication 6 **caractérisé en ce que** l'émission d'un signal sonore est déclenchée lorsque l'impédance apparente du circuit des contacts (7, 9) est inférieure à 50 Ω, correspondant à l'état fermé du contact de palier (9), quel que soit l'état du contact d'armoire.

## Patentansprüche

1. Modul für die akustische Kontrolle des Rufs eines Aufzugs, dessen Anlage einen Steuerschrank (1) und Treppenabsatzkästen (2) aufweist, die jeweils mit einem Rufbefehlsknopf und einer Rufkontrollleuchte ausgestattet sind, wobei jeder Treppenabsatzkasten (2) mit dem Steuerschrank (1) durch einen Massenleiter (4) und einen Leseleiter (6) verbunden ist, zwischen denen ein Schaltschrankkontakt (7) und ein Treppenabsatzkontakt (9) angeordnet sind, **dadurch gekennzeichnet, dass** das Modul (3) einen mit dem Leseleiter (6) verbundenen Messkondensator (13) aufweist, wobei ein Impulsgenerator (14) Impulse an den Messkondensator (13) liefert, wobei ein Messkreis (18) die Last des Messkondensators (13) misst, wobei ein Vergleicher (19) den Messwert der Last des Messkondensators (13) mit einem Grenzwert vergleicht, und wobei ein logischer Kreis (15) in Abhängigkeit vom Ausgangszustand des Vergleichers (19) einen akustischen Sender (16) kontrolliert.

2. Modul nach Anspruch 1, **dadurch gekennzeichnet, dass** der logische Kreis (15) den Impulsgenerator (14) und einen Entlastungskreis (17) kontrolliert, der den Messkondensator (13) vor der Ausgabe jedes Impulses durch den Impulsgenerator (14) entlastet.

3. Modul nach Anspruch 1, **dadurch gekennzeichnet, dass** der Messkondensator (13) mit dem Leseleiter (6) über einen Isolationskondensator (12) verbunden ist.

4. Modul nach Anspruch 1, **dadurch gekennzeichnet, dass** die dem Messkondensator (13) gelieferten Impulse eine Amplitude unter 0,6 V und eine Dauer unter 1 µs haben.

5. Modul nach Anspruch 4, **dadurch gekennzeichnet, dass** die dem Messkondensator (13) gelieferten Impulse eine Amplitude von 0,5 V und eine Dauer von 0,3 µs haben.

6. Verfahren für die akustische Kontrolle des Rufs eines Aufzugs, der mit einem akustischen Kontrollmodul nach einem der Ansprüche 1 bis 5 ausgestattet ist, das durch die folgenden Schritte gekennzeichnet ist:
- Messen der Last des Messkondensators (13) in Abhängigkeit von der Scheinimpedanz des Kreises der Steuerschrank- (7) und Treppenabsatzkontakte (9) mit Hilfe eines Impulses,
- Vergleichen der Messergebnisse mit einem Grenzwert,
- Auslösen der Ausgabe eines Tonsignals in Abhängigkeit vom Ergebnis des Vergleichs.

7. Verfahren nach Anspruch 6, **dadurch gekennzeichnet, dass** die Ausgabe eines Tonsignals ausgelöst wird, wenn die Scheinimpedanz des Kreises der Kontakte (7, 9) unter 50 Ω ist, was dem geschlossenen Zustand des Treppenabsatzkontakts (9) unabhängig vom Zustand des Schaltschrankkontakts entspricht.

## Claims

1. A module for the auditory control of the calling of a lift, the installation of which includes a switch cabinet (1) and landing boxes (2) each equipped with a call command button and a call control light indicator, each landing box (2) being connected to the switch cabinet (1) by a ground conductor (4), and a readout conductor (6), between which a cabinet contact (7) and a landing contact (9) are arranged, **characterized in that** the module (3) includes a measuring capacitor (13) connected to said readout conductor (6), a pulse generator (14) delivering pulses to the measuring capacitor (13), a measuring circuit (18) measuring the load of the measuring capacitor (13), a comparator (19) comparing said measurement of the load of the measuring capacitor (13) to a threshold value, and a logic circuit (15) controlling a sound emitter (16) based on the output state of the comparator (19).

2. The module according to claim 1, **characterized in that** the logic circuit (15) controls the pulse generator (14) and a discharge circuit (17) that discharges the measuring capacitor (13) before each pulse is delivered by the pulse generator (14).

3. The module according to claim 1, **characterized in that** the measuring capacitor (13) is connected to the readout conductor (6) by an isolating capacitor (12).

4. The module according to claim 1, **characterized in that** the pulses delivered to the measuring capacitor (13) have an amplitude below 0.6 V and a duration below 1 µs.

5. The module according to claim 4, **characterized in that** the pulses delivered to the measuring capacitor (13) have an amplitude of 0.5 V and a duration of 0.3 µs.

6. A method for the auditory control of the calling of a lift equipped with an auditory control module according to one of claims 1 to 5, **characterized by** the following steps:
- measuring the load of the measuring capacitor (13), using a pulse, based on the apparent impedance of the circuit of the cabinet (7) and landing (9) contacts,
- comparing the result of the measurement to a threshold value,
- based on the result of the comparison, activating the emission of a sound signal.

7. The method according to claim 6, **characterized in that** the emission of a sound signal is activated when the apparent impedance of the circuit of the contacts (7, 9) is less than 50 Ω, corresponding to the closed state of the landing contact (9), irrespective of the state of the cabinet contact.
